(19) Europäisches Patentamt
European Patent Office
Office européen des brevets

(11) **EP 2 197 198 A2**

(12) **EUROPEAN PATENT APPLICATION**

(43) Date of publication:
**16.06.2010 Bulletin 2010/24**

(51) Int Cl.:
***H04N 5/32*** *(2006.01)*

(21) Application number: **09178320.9**

(22) Date of filing: **08.12.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **12.12.2008 JP 2008317274**

(71) Applicant: **Canon Kabushiki Kaisha**
**Tokyo 146-8501 (JP)**

(72) Inventors:
• **Yokoyama, Keigo**
**Tokyo, Tokyo 146-8501 (JP)**

• **Endo, Tadao**
**Tokyo, Tokyo 146-8501 (JP)**
• **Kameshima, Toshio**
**Tokyo, Tokyo 146-8501 (JP)**
• **Yagi, Tomoyuki**
**Tokyo, Tokyo 146-8501 (JP)**
• **Takenaka, Katsuro**
**Tokyo, Tokyo 146-8501 (JP)**

(74) Representative: **TBK-Patent**
**Bavariaring 4-6**
**80336 München (DE)**

(54) **Image pickup apparatus and image pickup system**

(57) An apparatus includes a detector (101) including pixels (201) which converts radiation or light into analog electric signals, a signal processor (105) including a reading circuit (103) which reads an analog electric signal output from the detector (101) and an A/D convertor (104) which converts the analog electric signal into a digital signal, a power-supply unit (106) which applies bias to the detector (101) and the signal processor (105), and a controller (109) which controls at least one of the signal processor (105) and the power-supply unit (106) based on information on an A/D conversion characteristic of the A/D convertor (104) and information on an input analog electric signal to be input to the A/D convertor (104).

FIG. 1

EP 2 197 198 A2

**Description**

BACKGROUND OF THE INVENTION

Field of the Invention

The present invention relates to image pickup apparatuses and image pickup systems, and more particularly to an image pickup apparatus and an image pickup system which are capable of reading signals using a plurality of A/D convertors and outputting the signals as digital signals.

Description of the Related Art

In recent years, as an image pickup apparatus used for medical image diagnostics and nondestructive inspection using X-rays, a radiographic image pickup apparatus including a flat panel detector (FPD) formed of semiconductor material has been in practical use. Such a radiographic image pickup apparatus using an FPD performs digital photographing by converting radiation such as an X-ray which is transmitted through an examinee such as a patient into an analog electric signal using the FPD, and converting the analog electric signal into a digital image signal. Examples of the FPD included in the radiographic image pickup apparatus include a direct-conversion FPD and an indirect-conversion FPD. A direct-conversion radiographic image pickup apparatus includes an FPD in which pixels having conversion elements which are formed of semiconductor material such as a-Se which is capable of directly converting radiation into electric charge are arranged in a matrix. An indirect-conversion radiographic image pickup apparatus includes an FPD in which pixels having wavelength conversion members such as fluorescent members capable of converting radiation into light and photoelectric conversion members formed of semiconductor material such as a-Si capable of converting light into electric charge are arranged in a matrix. In a field of medical image diagnostics, such a radiographic image pickup apparatus including an FPD is used as a digital image pickup apparatus for general shooting of still images and shooting of moving-images such as fluorography.

The radiographic image pickup apparatus outputs, in addition to image signals obtained using radiation transmitted through an examinee at photographing, image signals used to correct the image signals obtained at photographing such as image signals for offset correction and image signals for sensitivity correction. The image signals for offset correction are based on output (dark output) obtained in a state in which light or radiation is not irradiated on the detector. Furthermore, the image signals for sensitivity correction are based on output (light output) obtained in a state in which light or radiation is substantially uniformly irradiated on the detector. Since image signals obtained at photographing are corrected using such image signals for correction, image signals of low noise and with high accuracy can be obtained.

Moreover, the radiographic image pickup apparatus includes, in addition to the detector, a driving circuit used to drive the detector, a reading circuit which reads an analog electric signal from the detector, and an A/D convertor which converts the analog electric signal into a digital signal. The A/D convertor outputs an image signal which has been obtained at photographing and the image signal for correction which are digitized.

However, the A/D convertor may generate nonlinear error. When the nonlinear error occurs, an ideal linear characteristic is not obtained as a conversion characteristic (A/D conversion characteristic) between an input analog electric signal and an output digital signal. Therefore, an image generated using digital signals may include noise and nonuniformity generated due to the nonlinear error of the A/D convertor. When the noise and the nonuniformity are generated, the nonlinear error is prevented or influence of the nonlinear error is corrected.

Japanese Patent Laid-Open No. 2005-210480 discloses an A/D conversion circuit which stores a reference signal synchronized with a signal output from an A/D conversion unit as address data in an address specified by the A/D conversion unit and corrects the signal output from the A/D conversion unit in accordance with the reference signal. With this configuration, an image nonuniformity generated due to a nonlinear error of the A/D conversion unit can be reduced and high image quality is realized.

Furthermore, Japanese Patent Laid-Open No. 2007-017650 discloses A/D conversion apparatus which include LUTs (Look Up Tables) which are paired with a plurality of A/D conversion circuits and which are set in accordance with input-output characteristics of the corresponding A/D conversion circuits, which converts digital signals supplied to the LUTs into values in accordance with a predetermined input-output signal characteristic, and which outputs the converted signals. In this way, a difference among the characteristics of the A/D conversion circuits is corrected, and the A/D conversion circuits individually output signals in accordance with the predetermined input-output characteristic. The A/D conversion circuits and the A/D conversion apparatuses according to the Japanese Patent Laid-Open Nos. 2005-210480 and 2007-017650 reduce noise and nonuniformity caused by the nonlinear error of the A/D convertors by correcting digital signals output from the A/D convertors as described above.

SUMMARY OF THE INVENTION

According to an embodiment of the present invention, there is provided an apparatus including a detector including a plurality of pixels which converts radiation or light into analog electric signals, a signal processor including a reading circuit which reads an analog electric signal output and an A/D convertor which converts the analog electric signal into a digital signal, a power-supply unit configured to apply bias to the detector and the signal processor, and a controller configured to control at least one of the signal processor and the power-supply unit in accordance with information on an A/D conversion characteristic of the A/D convertor and information on an input analog electric signal to be input to the A/D convertor.

Further features of the present invention will become apparent from the following description of exemplary embodiments with reference to the attached drawings.

The present invention in its first aspect provides an image pickup apparatus as specified in claims 1 to 7.

The present invention in its second aspect provides an image pickup system as specified in claim 8.

The present invention in its third aspect provides an image pickup system as specified in claims 9 to 13.

Further features of the present invention will become apparent from the following description of exemplary embodiments with reference to the attached drawings.

BRIEF DESCRIPTION OF THE DRAWINGS

Fig. 1 is a block diagram schematically illustrating an image pickup apparatus according to a first embodiment of the present invention.

Fig. 2 is a diagram schematically illustrating an image pickup system including an equivalent circuit of the image pickup apparatus according to the first embodiment of the present invention.

Figs. 3A to 3C are graphs illustrating input-output characteristics used for explanation of INL and DNL of an A/D convertor.

Figs. 4A and 4B illustrates a flowchart of control processing according to the first embodiment of the present invention.

Figs. 5A and 5B illustrates a flowchart of control processing according to a second embodiment of the present invention.

Figs. 6A and 6B are diagrams schematically illustrating radiographic image pickup systems using the image pickup apparatuses according to the embodiments of the present invention.

DESCRIPTION OF THE EMBODIMENTS

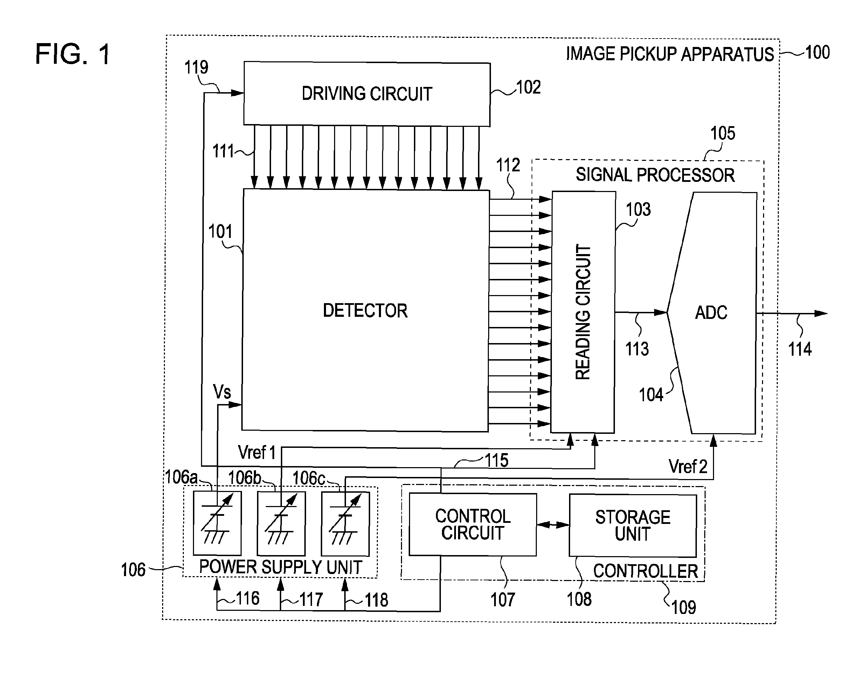

Fig. 1 is a block diagram schematically illustrating an image pickup apparatus 100 according to a first embodiment of the present invention. The image pickup apparatus 100 shown in Fig. 1 includes a detector 101 including a plurality of pixels used to convert radiation or light into an analog electric signal and a driving circuit 102 which drives the detector 101 so that the detector 101 outputs the analog electric signal. In the embodiment, electromagnetic rays such as X-rays and γ-rays, α-rays, and β-rays can be included in radiation. The image pickup apparatus 100 further includes a signal processor 105 including a reading circuit 103 which reads the analog electric signal supplied from the detector 101 and an A/D convertor 104 which converts an analog electric signal 113 supplied from the reading circuit 103 into a digital signal 114. The image pickup apparatus 100 further includes a power supply unit 106 which individually applies bias to the detector 101 and the signal processor 105. The power supply unit 106 includes a bias power supply 106a which supplies a sensor bias Vs to the detector 101, a first reference power supply 106b which supplies a first reference voltage Vref1 to the reading circuit 103, and a second reference power supply 106c which supplies a second reference voltage Vref2 to the A/D convertor 104. The image pickup apparatus 100 further includes a controller 109 which controls at least one of the signal processor 105 and the power supply unit 106.

The controller 109 includes a storage unit 108 which stores information on an A/D conversion characteristic of the A/D convertor 104 and a control circuit 107 which controls at least one of the signal processor 105 and the power supply unit 106 on the basis of the information. The control circuit 107 supplies a gain controlling signal 116, a reference voltage controlling signal 117, and a reference voltage controlling signal 118 to the bias power supply 106a, the first reference power supply 106b, and the second reference power supply 106c, respectively. Furthermore, the control circuit 107 supplies a gain controlling signal 115 to the reading circuit 103. Moreover, the control circuit 107 supplies a driving control signal 119 to the driving circuit 102, and the driving circuit 102 supplies driving signals 111 to the detector 101 in accordance with the driving control signal 119.

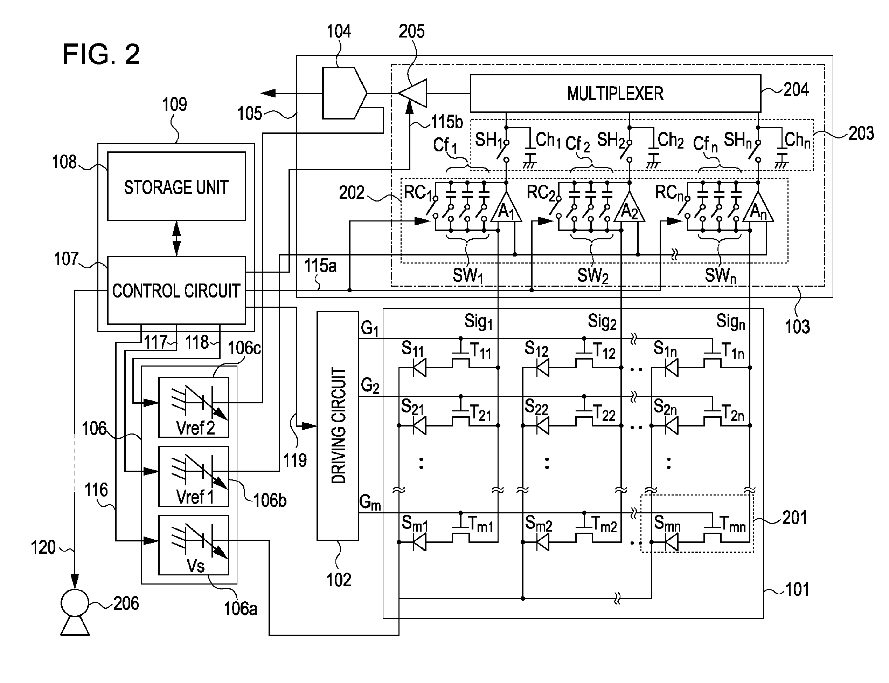

Fig. 2 is a diagram schematically illustrating an image pickup system including an equivalent circuit of the image pickup apparatus according to the first embodiment of the present invention. Note that components the same as those shown in Fig. 1 are denoted by reference numerals the same as those shown in Fig. 1, and detailed descriptions thereof are omitted. The detector 101 includes a plurality of pixels 201 arranged in a matrix. In Fig. 2, m x n pixels 201 are arranged in a matrix having m rows and n columns. Each of the pixels 201 includes a conversion element S which converts radiation or light into electric charge and a switch element T which outputs an electric signal in accordance with the electric charge. As the conversion element S which converts light into electric charge, a photoelectric conversion element such as a PIN photodiode or an MIS conversion element which is mainly formed of amorphous silicon and which is disposed on an insulating substrate such as a glass substrate is suitably used. As the conversion element S which converts radiation into electric charge, an indirect conversion element including, on a radiation receiving side of the photoelectric conversion element, a wavelength conversion member which converts radiation into light in a wavelength band which can be sensed by the photoelectric conversion element or a direct conversion element which directly converts radiation into electric charge is suitably used. As the switch element T, a transistor having a control terminal and first and second main terminals is suitably used. When each of the pixels 201 includes the photoelectric conversion element arranged on the insulating substrate, a thin-film transistor (TFT) is suitably used as the switch element T. The conversion element S has one electrode electrically connected to the first main terminal of the switch element T and the other electrode electrically connected to the bias power supply 106a through common wiring. A plurality of switch elements, such as switch elements $T_{11}$ to $T_{1n}$, arranged in the same row each have control terminals electrically connected to a first driving line $G_1$ in common. The driving circuit 102 supplies driving signals used to control conductive states of the switch elements to the control terminals through driving lines for individual rows. A plurality of switch elements, such as switch elements $T_{11}$ to $T_{m1}$, arranged in the same column each have the second main terminals electrically connected to a signal line $Sig_1$ of a first column. While the switch elements are in conductive states, the switch elements output electric signals corresponding to electric charge of the conversion elements to the reading circuit 103 through signal lines. A plurality of signal lines $Sig_1$ to $Sig_n$ arranged in the column direction are used to transmit electric signals output from the pixels 201 included in the detector 101 to the reading circuit 103 in parallel.

The reading circuit 103 includes an amplifying circuit unit 202 which amplifies electric signals output in parallel from the detector 101 and a sample-and-hold circuit unit 203 which samples and holds electric signals supplied from the amplifying circuit unit 202. The amplifying circuit unit 202 includes amplifying circuits for individual signal lines. Each of the amplifying circuit includes a calculation amplifier A which amplifies and outputs a read electric signal, an integral capacitor group Cf, a switch group SW used to change an amplification factor, and a reset switch RC which resets an integral capacitor. The calculation amplifier A has a reverse input terminal which receives an output electric signal, a normal input terminal which receives the first reference voltage Vref1 supplied from the first reference power supply 106b, and an output terminal which outputs an electric signal which has been amplified. The integral capacitor group Cf including a plurality of integral capacitors arranged in parallel is interposed between the reverse input terminal and the output terminal of the calculation amplifier A. The sample-and-hold circuit unit 203 includes, for individual amplifying circuits, sample-and-hold circuits each of which includes a sampling switch SH and a sampling capacitor Ch. The reading circuit 103 further includes a multiplexer 204 which successively outputs electric signals which have been read in parallel from the sample-and-hold circuit unit 203 as image serial signals, and a variable amplifier 205 serves as an output buffer which outputs an image signal after performing impedance conversion on the image signal. The image signal which is an analog electric signal output from the reading circuit 103 is converted into a digital image signal by the A/D convertor 104 and the digital image signal is output from the A/D convertor 104. The A/D convertor 104 receives the second reference voltage Vref2 supplied from the second reference power supply 106c.

The control circuit 107 shown in Fig. 2 supplies a gain controlling signal 115a included in the gain controlling signal 115 shown in Fig. 1 to each of the switch groups SW and supplies a gain controlling signal 115b included in the gain controlling signal 115 to the variable amplifier 205. The control circuit 107 further supplies a radiation-dose controlling signal 120 used to control dose of radiation to be radiated to a radiation generating device 206 such as an X-ray source. The control circuit 107 controls at least one of the signal processor 105 and the power supply unit 106 in accordance with information on an A/D conversion characteristic of the A/D convertor 104 stored in the storage unit 108.

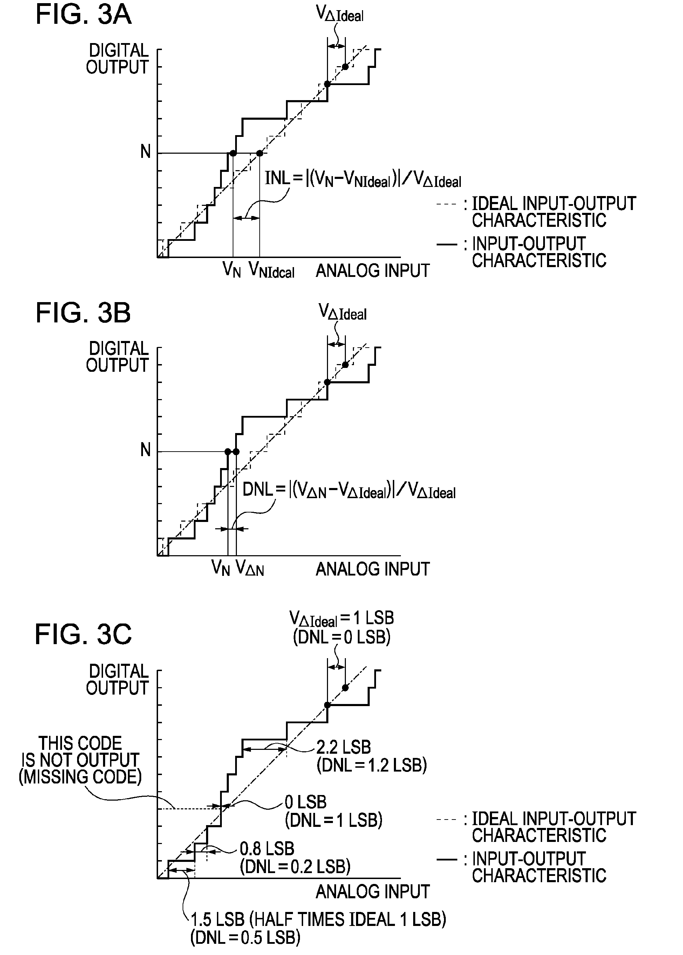

The information on the A/D conversion characteristic of the A/D convertor 104 stored in the storage unit 108 includes the following information. First, information on nonlinearity of the A/D convertor 104 is stored. The nonlinearity represents a difference between the actual relationship between an analog input and a digital output (A/D conversion value) and an ideal line. Specifically, the nonlinearity is denoted by a differential nonlinearity (DNL) or an integral nonlinearity (INL). Referring to Figs. 3A and 3B, the INL and the DNL will be described. The INL represents a deviation of an actual input-output characteristic relative to an ideal input-output line in an entire input-output characteristic of the A/D convertor 104. The INL is a value which is obtained by standardizing an amount of a deviation between an ideal value $V_{NIdeal}$ of an analog input amount used for outputting a digital output N by the A/D convertor 104 and an analog input amount VN used for actually obtaining the output N using an ideal analog input amount $V_{\Delta Ideal}$ used for changing the digital output by 1 LSB. That is, the INL is represented by the following expression 1.

$$INL = |(V_N - V_{NIdeal})|/V_{\Delta Ideal} \qquad (\text{Expression 1})$$

Here, the ideal value $V_{NIdeal}$ of the analog input amount used for outputting the digital output N is obtained by multiplying the analog input amount $V_{\Delta Ideal}$ used for changing the digital output by 1 LSB by N and adding a resultant value to an offset $V_{offset}$ of the A/D convertor. The ideal value $V_{NIdeal}$ is represented by the following expression 2.

$$V_{NIdeal} = N \times V_{\Delta Ideal} + V_{offset} \qquad (\text{Expression 2})$$

The DNL represents a deviation relative to ideal steps when input steps and output steps are individually observed. Specifically, the DNL is a value obtained by standardizing an amount of a deviation between a changing amount $V_{\Delta N}$ of an analog input amount used for changing the digital output N to a digital output N+1 (by 1 LSB) and the ideal analog input amount $V_{\Delta Ideal}$ using the ideal analog input amount $V_{\Delta Ideal}$. That is, the DNL is represented by the following expression 3.

$$DNL = |(V_{\Delta N} - V_{\Delta Ideal})|/V_{\Delta Ideal} \qquad (\text{Expression 3})$$

Next, information on an output error of the A/D convertor 104 caused by the nonlinearity is stored. The INL and the DNL cause an input-output error. When the input-output error occurs, a digital signal which is actually output is shifted from a digital signal which corresponds to an actual analog input amount. Furthermore, as shown in Fig. 3C, when the DNL is larger than ±1/2 LSB a digital signal which should be output may not be output from the A/D convertor 104. This is called as a missing code. Information on the input-output error of the A/D convertor 104 and information on the missing code are included in information on an output error of the A/D convertor 104.

Furthermore, the storage unit 108 stores information on an input analog electric signal to be supplied to the A/D convertor 104. This information includes information on a range of the input analog electric signal when an image signal for offset correction is obtained, information on a range of an input analog electric signal when an image signal for sensitivity correction is obtained, and information on a range of an input analog electric signal when an image signal is obtained at a time of actual photographing. Specifically, when the image pickup apparatus 100 obtains an image signal for correction such as the image signal for the offset correction and the image signal for the sensitivity correction, a width of an analog electric signal supplied to the A/D convertor 104 is limited to a considerably narrow range relative to an entire dynamic range, and accordingly, prediction with high accuracy is realized. Furthermore, since the image signal for correction is limited to a narrow range, influence of the input-output error or the missing code of the A/D convertor 104 is larger than a case of the image signal obtained when photographing is performed. If the image signal for correction is considerably affected, accuracy of correction is considerably affected. Therefore, it is important for the image signal for correction to avoid the influence of the input-output error or the missing code in order to improve the correction accuracy. The information on an input analog electric signal to be input is obtained or stored in advance in accordance with a moving-image shooting operation, a still-image shooting operation, or an operation of obtaining a correction image before shipping or installation. Note that the present invention is not limited to this, and an analog electric signal immediately before being actually supplied to the A/D convertor 104 may be monitored and information on a range of the analog electric signal may be obtained in a real time, and control may be performed in accordance with the information.

The control circuit 107 can control at least one of the signal processor 105 and the power supply unit 106 in accordance with the information on the A/D conversion characteristic of the A/D convertor 104 stored in the storage unit 108. That is, the controller 109 including both the control circuit 107 and the storage unit 108 can control at least one of the signal processor 105 and the power supply unit 106 in accordance with the A/D conversion characteristic of the A/D convertor 104. Here, the control circuit 107 determines the control on the basis of the information on an input analog electric signal to be input to the A/D convertor 104 and at least one of the information on the nonlinearity of the A/D convertor 104 and the information on the output error of the A/D convertor 104. Then, in accordance with the information on the A/D conversion characteristic, the control circuit 107 controls at least one of the signal processor 105 and the power supply unit 106 so that the analog electric signal input to the A/D convertor 104 does not induce the A/D conversion characteristic of the A/D convertor 104 to enter an undesirable range. The undesirable range of the A/D conversion characteristic of the A/D convertor 104 is a range in which the A/D conversion characteristic includes the missing code and a range in which the input-output error of the A/D convertor 104 is larger than a predetermined value, i.e., a range in which a standard deviation of the input-output error is larger than 3σ. The predetermined value can be appropriately set in accordance with a form and a configuration. Specifically, the control circuit 107 determines and appropriately changes an amplification factor of the amplifying circuit unit 202 or the variable amplifier 205 included in the reading circuit 103 of the signal processor 105. For example, as for an amplification factor of the amplifying circuit unit 202, the switch groups SW used to change the amplification factor determine capacitance values of the integral capacitor groups Cf. Furthermore, the control circuit 107 determines whether at least one of the bias power supply 106a, the first reference power supply 106b, and the second reference power supply 106c included in the power supply unit 106 is to be changed, and changes at least one of them where appropriate. When the sensor bias Vs supplied from the bias power supply 106a is changed, sensitivity of the detector 101 is changed. When the first reference voltage Vref1 supplied from the first reference power supply 106b is changed, a positive or negative direct current component is added to an analog electric signal to be supplied to the amplifying circuit unit 202, and an analog signal output from the amplifying circuit unit 202 is changed. The determination and the change of the first reference voltage Vref1 may be performed for each calculation amplifier A. Alternatively, the determination and the change of the first reference voltage Vref1 may be performed in a unit of a group of a plurality of calculation amplifiers A. Similarly, the determination and the change may be performed by the entire amplifying circuit unit 202. Furthermore, when the second reference voltage Vref2 supplied from the second reference power supply 106c is changed, that is, a reference voltage of the A/D convertor 104 is changed, the undesirable range of the A/D conversion characteristic of the A/D convertor 104 is changed. The controller 109 of this embodiment of the present invention performs control to reduce the number of pixels which output input analog signals corresponding to the undesirable range of the A/D conversion characteristic among pixels which output input analog signals serving as image signals. In other words, the number of input analog signals corresponding to the undesirable range of the A/D conversion characteristic among all input analog signals serving as image signals is reduced by the control described above. For example, the controller 109 of this embodiment of the present invention selectively performs the control described above where appropriate so that an average value of analog electric signals supplied to the A/D convertor 104 is not included in the undesirable range of the A/D conversion characteristic of the A/D convertor 104. Moreover, the controller 109 of this embodiment of the present invention selectively performs the control described above where appropriate so that the analog electric signal to be input to the A/D convertor 104 is not included in the undesirable range of the A/D conversion characteristic of the A/D convertor 104. Note that the change of a gain of the image pickup apparatus 100 due to the change of the amplification factor of the bias power supply 106a or the reading circuit 103, the addition of a direct current component due to the change of the first reference power supply 106b, or the level change of the A/D convertor 104 due to the change of the second reference power supply 106c is appropriately selected depending on a shooting condition. The control by the controller 109 described above is performed so that an input analog electric signal supplied from the reading circuit 103 is included in a dynamic range of the A/D convertor 104. Furthermore, after the control described above is performed when an image signal for correction is obtained, when another image signal for correction is obtained or when an image signal at a time of actual shooting is obtained, operation is performed in accordance with items including changed items. Note that known variable voltage source is appropriately used for the bias power supply 106a, the first reference power supply 106b, and the second reference power supply 106c. A microcomputer, an FPGA (Field Programmable Gate Array), a custom IC or the like is appropriately used for the control circuit 107.

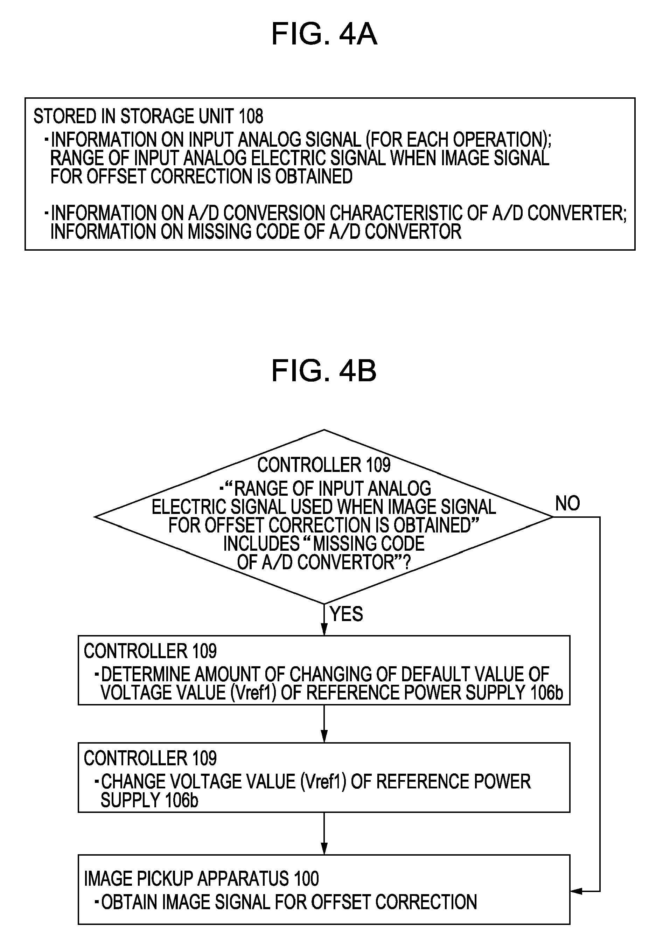

Hereinafter, an example of the control will be described in detail with reference to the accompanying drawings. Fig. 4 shows a flowchart of the control according to this embodiment. In this example, the information on the missing code is used as information on an output error of the A/D convertor 104, and the information on the range of an input analog electric signal when an image signal is obtained for offset correction is used as information on an input analog electric signal. Then, the controller 109 controls the first reference power supply 106b included in the power supply unit 106 so as to determine whether the first reference voltage Vref1 to be supplied to the amplifying circuit unit 202 is changed.

In Fig. 4A, before shipping or installation of the apparatus, the range of an input analog electric signal when an image signal for offset correction is obtained every time an operation such as still-image shooting or moving-image shooting is performed is stored in the storage unit 108. Here, the amplification factor of the amplifying circuit unit 202, the sensor bias Vs of the bias power supply 106a, the first reference voltage Vref1 of the first reference power supply 106b, and the second reference voltage Vref2 of the second reference power supply 106c are stored in the storage unit 108 as default values. The default values are used as default values at a time of actual shooting. Furthermore, the storage unit 108 stores the information on the missing code of the A/D convertor 104.

In Fig. 4B, the image pickup apparatus 100 performs the following operation when an operation of obtaining an image signal for offset correction is started. The control circuit 107 refers to the information on the missing code and the information on the range of the input analog electric signal among the information stored in the storage unit 108 depending on a shooting operation performed afterward. Then, it is determined whether the missing code of the A/D convertor 104 is included in the range of the input analog electric signal. When the determination is negative, the controller 109 determines voltages supplied from the power supply unit 106 as default values. Then, the controller 109 controls the image pickup apparatus 100 to obtain the image signal for offset correction. On the other hand, when the determination is affirmative, a direct current component should be applied to the input analog electric signal so that the range of the input analog electric signal does not overlap with the missing code. The controller 109 determines an amount of change of the voltage value of the first reference power supply 106b which is a direct current component from the default value. In accordance with the determination, the controller 109 supplies the reference voltage controlling signal 117 to the first reference power supply 106b so as to change the first reference voltage Vref1. Then, in a state in which the changed first reference voltage Vref1 is supplied to the amplifying circuit unit 202, the controller 109 controls the image pickup apparatus 100 so as to obtain the image signal for offset correction. Note that although the information on the missing code is used as the information on the output error of the A/D convertor 104 in the example described above, the present invention is not limited to this. If the information on nonlinearity of the A/D convertor 104 is used instead of the information on an output error, the control circuit 107 may generate the information on an output error using the information on nonlinearity to be used for the control. Furthermore, although the operation of obtaining the image signal for offset correction is described above, the present invention is not limited to this. The information may be used for an operation of obtaining an image signal for sensitivity correction or an image signal at a time of actual shooting. Note that since a width of the input analog electric signal when the image signal is obtained is restricted to a considerably narrow range when compared with a case of actual shooting, the present invention is more employed when an image signal for correction is obtained.

According to this embodiment, the number of pixels corresponding to analog electric signals which induce the A/D conversion characteristic of the A/D convertor 104 to enter the undesirable range can be reduced. Furthermore, the analog electric signal to be input to the A/D convertor 104 does not induce the A/D conversion characteristic of the A/D convertor 104 to enter the undesirable range. Therefore, even if the A/D convertor 104 includes the undesirable range of the A/D conversion characteristic, A/D conversion can be easily performed with high accuracy when compared with a method for performing correction processing on a digital signal which has been subjected to A/D conversion. Furthermore, A/D conversion can be performed with high accuracy using a small simple circuit when compared with a circuit which corrects a digital signal.

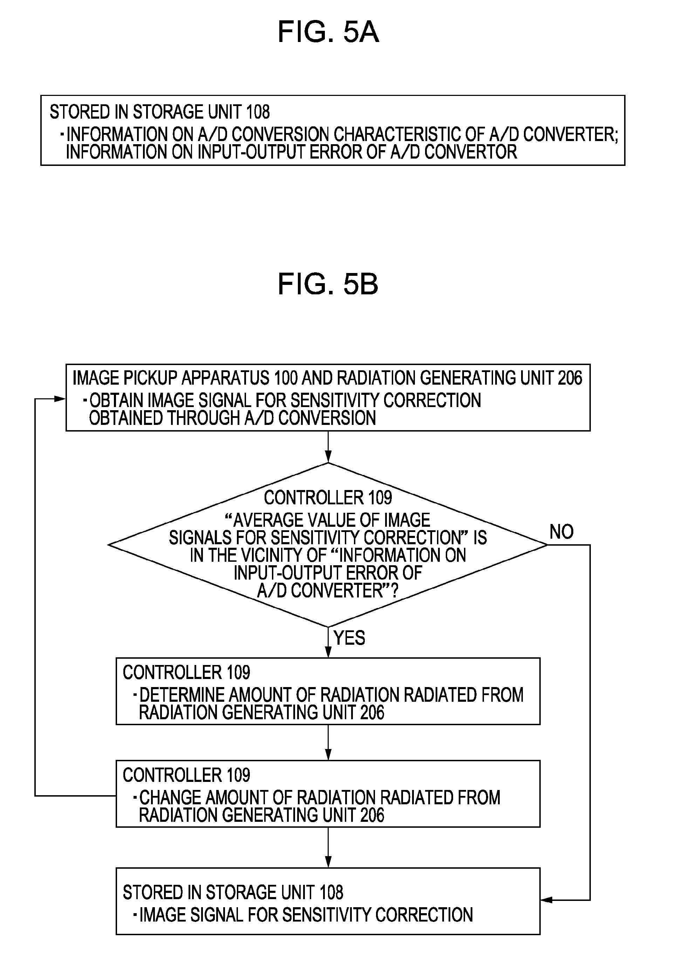

Next, a second embodiment of the present invention will be described with reference to Figs. 2, 3, and 5. Note that components the same as those described in the first embodiment are denoted by reference numerals the same as those of the first embodiment, and descriptions thereof are omitted. Fig. 5 shows a flowchart illustrating a control operation of this embodiment.

The second embodiment is different from the first embodiment in that, although the information on the missing code is used as the information on an output error of the A/D convertor 104 in the first embodiment, information on an input-output error is used in this embodiment.

Furthermore, in the first embodiment, the information on the range of the input analog electric signal when an image signal for offset correction is obtained which is stored in the storage unit 108 is used as the information on an input analog electric signal. However, in the second embodiment, an average value obtained by averaging image signals for sensitivity correction which have been obtained and subjected to A/D conversion is not stored in a storage unit 108 in advance but is directly used. This is different from the first embodiment.

Furthermore, in the first embodiment, the controller 109 determines and changes the voltage value of the first reference power supply 106b. However, in the second embodiment is different from the first embodiment in that a controller 109 determines and controls an amount of radiation radiated from a radiation generating device 206. Other configurations are the same as those of the first embodiment, and therefore, the same processing is performed.

First, in Fig. 5A, before shipping, the storage unit 108 stores a digital output value which obtains an input-output error larger than a predetermined value as information on an input-output error of an A/D convertor 104. Examples of the digital output value includes a digital output value in which DNL is larger than $\pm 1/2$ LSB or a digital output value in which a standard deviation of INL is larger than $3\sigma$. The information on an input-output error is appropriately set, and the input-output error is included in a range larger than a predetermined value.

Next, in Fig. 5B, the controller 109 activates the image pickup apparatus 100 and the radiation generating device 206 and obtains an average value of image signals for sensitivity correction which have been subjected to A/D conversion. Here, the storage unit 108 stores an operation condition of the radiation generating device 206. The control circuit 107 refers to the information on an input-output error of the A/D convertor 104 stored in the storage unit 108 and determines whether the average value is included in a region in the vicinity of a digital output value which causes a large input-output error. The range in the vicinity of the digital output value is appropriately set. When the determination is negative, the obtained image signal for sensitivity correction is determined as a proper image signal for correction and is stored in the storage unit 108. On the other hand, when the determination is affirmative, the number of pixels which output input analog signals corresponding to an undesired range of an A/D conversion characteristic should be reduced by control. The controller 109 determines an amount of radiation radiated from the radiation generating device 206. In accordance with the determination, the controller 109 supplies a radiation controlling signal 120 to the radiation generating device 206 so as to change the amount of radiation. Then, the controller 109 obtains an image signal for sensitivity correction again using the changed amount of radiation, and the same operation is repeatedly performed until it is determined that an average value of image signals for sensitivity correction is not included in the region in the vicinity of the digital output value which causes a large input-output error.

Note that although the information on an input-output error is used in this embodiment, the present invention is not limited to this and information on another A/D conversion characteristic may be appropriately used. Furthermore, although the image signal for sensitivity correction is described in this embodiment, the present invention is not limited to this, and the present invention may be appropriately employed for an image signal for offset correction and an image signal at actual shooting. However, in a case of the image signal for offset correction, the controller 109 does not control the amplifying circuit unit 202 but controls the signal processor 105 or the power supply unit 106. Furthermore, in a case of the image signal at actual shooting, the controller 109 controls at least one of the signal processor 105, the power supply unit 106, and the amplifying circuit unit 202. Moreover, although the storage unit 108 stores the image signal for sensitivity correction in this embodiment, the present invention is not limited to this, and another storage unit may be provided.

According to this embodiment, the number of pixels corresponding to analog electric signals which induce the A/D conversion characteristic of the A/D convertor 104 to enter an undesirable range can be reduced. Accordingly, even if the A/D convertor 104 includes the undesirable range of the A/D conversion characteristic, A/D conversion can be easily performed with high accuracy when compared with a method for performing correction processing on a digital signal which has been subjected to A/D conversion. Furthermore, A/D conversion can be performed with high accuracy using a small simple circuit when compared with a circuit which corrects a digital signal.

Application

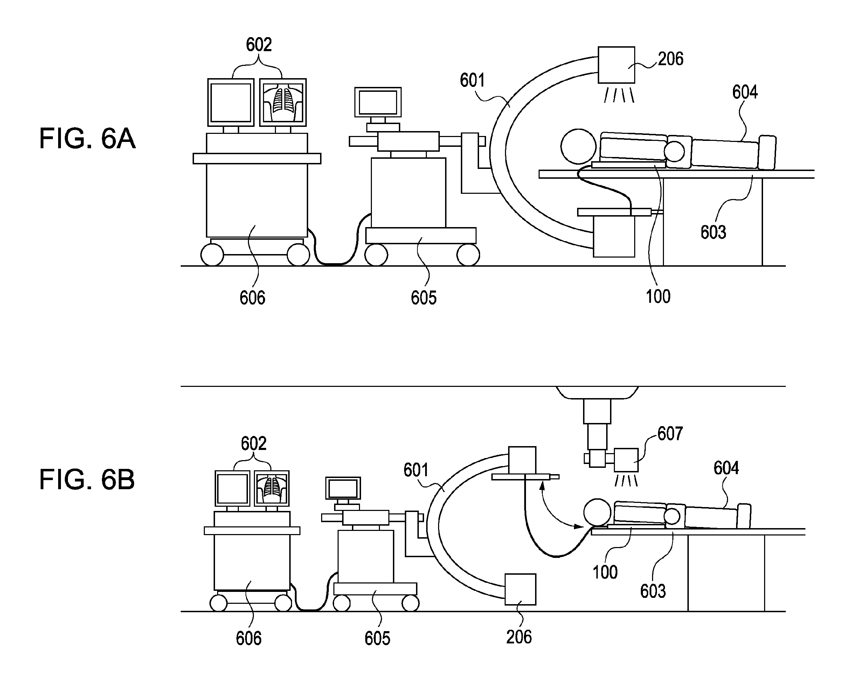

Next, an example of a transportable radiographic image pickup system to which the present invention is applied will be described with reference to Figs. 6A and 6B. Fig. 6A is a diagram schematically illustrating a radiographic image pickup system using a transportable radiographic image pickup apparatus capable of performing fluorography and still-image photographing. Fig. 6A shows an example of photographing performed such that an image pickup apparatus 100 is detached from a C-shaped arm 601, and the photographing is performed using a radiation generating device 206 included in the C-shaped arm 601. Note that the C-shaped arm 601 supports the radiation generating device 206 and the image pickup apparatus 100. A display unit 602 is capable of displaying an image signal obtained in the image pickup apparatus 100. An examinee 604 is placed on a bed 603. A carriage 605 is used to transport the radiation generating device 206, the image pickup apparatus 100, and the C-shaped arm 601. A transportable controller 606 controls the C-shaped arm 601, the display unit 602, the bed 603, and the carriage 605. The controller 606 also performs image processing on an image signal obtained by the image pickup apparatus 100 so as to obtain image data and transmits the image data to the display unit 602, for example. Furthermore, the image data obtained through the image processing performed by the controller 606 may be supplied to a distant place through a transmission unit such as a telephone line. By this, an image can be displayed on a display unit in another place such as a doctor room or the image can be stored in a storage unit such as an optical disc. Accordingly, a doctor in a distant place can diagnose. Furthermore, the transmitted image data may be recorded as a film by a film processor. Note that a part of or entire configuration of the controller 109 of this invention may be included in the image pickup apparatus 100 or the controller 606.

Fig. 6B shows another radiographic image pickup system using a transportable radiographic image pickup apparatus capable of performing fluorography and still-image photographing. Fig. 6B shows an example of photographing performed such that an image pickup apparatus 100 is detached from a C-shaped arm 601, and the photographing is performed using a radiation generating device 607 which is different from the radiation generating device 206. Note that it is apparent that the controller 109 of the present invention can control the radiation generating device 607 as well as the radiation generating device 206.

Note that the embodiments of the present invention can be realized when a computer executes a program, for example. Furthermore, a unit used to supply the program to the computer, i.e., a computer readable recording medium such as a CD-ROM (Compact Dick Read Only Memory) which records such a program, for example, and a transmission medium, such as the Internet, which transmits the program are also included in an embodiment of the present invention. The program, a recording medium, a transmission medium, and a program product are also included in the present invention. Note that an invention obtained by an imaginable combination according to the first and second embodiments is also included in the present invention.

While the present invention has been described with reference to exemplary embodiments, it is to be understood that the invention is not limited to the disclosed exemplary embodiments. The scope of the following claims is to be accorded the broadest interpretation so as to encompass all modifications, equivalent structures and functions. An apparatus includes a detector (101) including pixels (201) which converts radiation or light into analog electric signals, a signal processor (105) including a reading circuit (103) which reads an analog electric signal output from the detector (101) and an A/D convertor (104) which converts the analog electric signal into a digital signal, a power-supply unit (106) which applies bias to the detector (101) and the signal processor (105), and a controller (109) which controls at least one of the signal processor (105) and the power-supply unit (106) based on information on an A/D conversion characteristic of the A/D convertor (104) and information on an input analog electric signal to be input to the A/D convertor (104).

**Claims**

1. An apparatus comprising:

   a detector (101) including a plurality of pixels (201) which converts radiation or light into analog electric signals;
   a signal processor (105) including a reading circuit (103) which reads an analog electric signal output from the detector (101) and an A/D convertor (104) which converts the read analog electric signal into a digital signal;
   a power-supply unit (106) arranged to apply bias to the detector (101) and the signal processor (105); and
   a controller (109) arranged to control at least one of the signal processor (105) and the power-supply unit (106), in accordance with information on an A/D conversion characteristic of the A/D convertor (104) and information on an input analog electric signal to be input to the A/D convertor (104).

2. The apparatus according to Claim 1,
   wherein a number of pixels (201), corresponding to the analog electric signals which are input in a region in which the A/D conversion characteristic includes a missing code or a region in which an input-output error of the A/D convertor (104) is larger than a predetermined value, can be reduced.

3. The apparatus according to Claim 1,
   wherein the analog electric signal input to the A/D convertor (104) is not included in a region in which the A/D conversion characteristic includes a missing code or a region in which an input-output error of the A/D convertor (104) is larger than a predetermined value.

4. The apparatus according to any one of Claims 1 to 3,
   wherein the controller (109) includes a storage unit (108) which stores at least one of information on nonlinearity of the A/D convertor (104) and information on an output error of the A/D convertor (104) as information on the A/D conversion characteristic, and a control circuit (107) which controls at least one of the signal processor (105) and the power-supply unit (106) in accordance with the at least one of information items and the information on the input analog electric signal.

5. The apparatus according to any one of Claims 1 to 4,
   wherein the controller (109) controls at least one of the signal processor (105) and the power-supply unit (106), when an image signal for correction is obtained, in accordance with information on a range of the input analog electric signal when the image signal for correction is obtained as the information on the input analog electric signal.

6. The apparatus according to Claim 5,
   wherein the reading circuit (103) includes an amplifying circuit unit (202) arranged to amplify the analog electric signal, the power-supply unit (106) includes a bias power supply (106a) which supplies bias to the detector (101), a first reference power supply (106b) which supplies a first reference voltage to the amplifying circuit unit (202), and a second reference power supply (106c) which supplies a second reference voltage to the A/D convertor (104) wherein the controller (109) determines change of at least one of the bias, the first reference voltage, and the second reference voltage.

7. The apparatus according to Claim 1,
   wherein the controller (109) determines change of an amplification factor of the reading circuit (103).

8. An image pickup system including the image pickup apparatus according to Claim 1.

9. A system comprising:

   a detector (101) including a plurality of pixels which converts radiation into analog electric signals;
   an A/D convertor (104) arranged to convert an analog electric signal into a digital signal;
   a generating device (206) arranged to generate radiation; and
   a controller (109) arranged to control the generating device (206),

   wherein the controller (109) controls the generating device (206) in accordance with information on an A/D conversion characteristic of the A/D convertor (104) and information on an input analog electric signal to be input to the A/D convertor (104).

10. The system according to Claim 9,
wherein the controller (109) determines an amount of radiation to be radiated from the generating device (206) so that a number of pixels (201), corresponding to the analog electric signals which are input in a region in which the A/D conversion characteristic of the A/D convertor (104) includes a missing code or a region in which an input-output error of the A/D convertor (104) is larger than a predetermined value can be reduced, or
wherein the controller (109) determines an amount of radiation to be radiated from the generating device (206) so that the analog electric signal input to the A/D convertor (104) is not included in a region in which the A/D conversion characteristic of the A/D convertor (104) includes a missing code or a region in which an input-output error of the A/D convertor (104) is larger than a predetermined value.

11. The system according to any one of Claims 9 to 10,
wherein the controller (109) includes a storage unit (108) which stores at least one of information on nonlinearity of the A/D convertor (104) and information on an output error of the A/D convertor (104) as information on the A/D conversion characteristic, and a control circuit (107) which determines an amount of radiation to be radiated from the generating device (206) in accordance with the at least one of information items and the information on the input analog electric signal, preferably
the controller (109) determines an amount of radiation to be radiated from the generating device (206), before an image signal for correction is obtained, in accordance with information on a range of the input analog electric signal when the image signal for correction is obtained as the information on the input analog electric signal.

12. A method comprising:

converting radiation or light into analog electric signals by a detector including a plurality of pixels;
reading an analog electric signal by a reading circuit output from the detector and converting the read analog electric signal into a digital signal by an A/D converter of a signal processor;
applying bias to the detector and the signal processor by a power-supply unit; and
controlling at least one of the signal processor and the power-supply unit in accordance with information on an A/D conversion characteristic of the A/D convertor and information on an input analog electric signal.

13. The method according to Claim 12,
wherein a number of pixels, corresponding to the analog electric signals which are input in a region in which the A/D conversion characteristic includes a missing code or a region in which an input-output error of the A/D convertor is larger than a predetermined value, can be reduced.

14. The method according to Claim 12,
wherein the analog electric signal input to the A/D convertor is not included in a region in which the A/D conversion characteristic includes a missing code or a region in which an input-output error of the A/D convertor is larger than a predetermined value, or
wherein the controller includes a storage unit which stores at least one of information on nonlinearity of the A/D convertor and information on an output error of the A/D convertor as information on the A/D conversion characteristic, and a control circuit which controls at least one of the signal processor and the power-supply unit in accordance with the at least one of information items and the information on the input analog electric signal.

15. The method according to Claim 12,
wherein the controller controls at least one of the signal processor and the power-supply unit, when an image signal for correction is obtained, in accordance with information on a range of the input analog electric signal when the image signal for correction is obtained as the information on the input analog electric signal, or
wherein the reading circuit includes an amplifying circuit unit configured to amplify the analog electric signal, the power-supply unit includes a bias power supply which supplies bias to the detector, a first reference power supply which supplies a first reference voltage to the amplifying circuit unit, and a second reference power supply which supplies a second reference voltage to the A/D convertor.

FIG. 1

IMAGE PICKUP APPARATUS ⌐100

119

DRIVING CIRCUIT ⌐102

111

112

101

DETECTOR

105

SIGNAL PROCESSOR

103

READING CIRCUIT

ADC

113

104

114

Vs

Vref 1

115

Vref 2

106a    106b    106c

POWER SUPPLY UNIT

106

CONTROL CIRCUIT

STORAGE UNIT

CONTROLLER

116    117    118

107    108    109

EP 2 197 198 A2

FIG. 2

## FIG. 3A

DIGITAL
OUTPUT

$V_{\Delta \text{Ideal}}$

$\text{INL} = |(V_N - V_{N\text{Ideal}})| / V_{\Delta \text{Ideal}}$

N

--- : IDEAL INPUT-OUTPUT
CHARACTERISTIC

— : INPUT-OUTPUT
CHARACTERISTIC

$V_N$ $V_{N\text{Idcal}}$ ANALOG INPUT

## FIG. 3B

DIGITAL
OUTPUT

$V_{\Delta \text{Ideal}}$

N

$\text{DNL} = |(V_{\Delta N} - V_{\Delta \text{Ideal}})| / V_{\Delta \text{Ideal}}$

$V_N$ $V_{\Delta N}$ ANALOG INPUT

## FIG. 3C

$V_{\Delta \text{Ideal}} = 1 \text{ LSB}$
$(\text{DNL} = 0 \text{ LSB})$

DIGITAL
OUTPUT

THIS CODE
IS NOT OUTPUT
(MISSING CODE)

2.2 LSB
$(\text{DNL} = 1.2 \text{ LSB})$

0 LSB
$(\text{DNL} = 1 \text{ LSB})$

--- : IDEAL INPUT-OUTPUT
CHARACTERISTIC

— : INPUT-OUTPUT
CHARACTERISTIC

0.8 LSB
$(\text{DNL} = 0.2 \text{ LSB})$

ANALOG INPUT

1.5 LSB (HALF TIMES IDEAL 1 LSB)
$(\text{DNL} = 0.5 \text{ LSB})$

13

# FIG. 4A

STORED IN STORAGE UNIT 108
  ·INFORMATION ON INPUT ANALOG SIGNAL (FOR EACH OPERATION);
   RANGE OF INPUT ANALOG ELECTRIC SIGNAL WHEN IMAGE SIGNAL
   FOR OFFSET CORRECTION IS OBTAINED

  ·INFORMATION ON A/D CONVERSION CHARACTERISTIC OF A/D CONVERTER;
   INFORMATION ON MISSING CODE OF A/D CONVERTOR

# FIG. 4B

CONTROLLER 109
·"RANGE OF INPUT ANALOG
ELECTRIC SIGNAL USED WHEN IMAGE SIGNAL
FOR OFFSET CORRECTION IS OBTAINED"
INCLUDES "MISSING CODE
OF A/D CONVERTOR"?

NO

YES

CONTROLLER 109
  ·DETERMINE AMOUNT OF CHANGING OF DEFAULT VALUE OF
   VOLTAGE VALUE (Vref1) OF REFERENCE POWER SUPPLY 106b

CONTROLLER 109
  ·CHANGE VOLTAGE VALUE (Vref1) OF REFERENCE POWER
   SUPPLY 106b

IMAGE PICKUP APPARATUS 100
  ·OBTAIN IMAGE SIGNAL FOR OFFSET CORRECTION

# FIG. 5A

STORED IN STORAGE UNIT 108
  ·INFORMATION ON A/D CONVERSION CHARACTERISTIC OF A/D CONVERTER;
   INFORMATION ON INPUT-OUTPUT ERROR OF A/D CONVERTOR

# FIG. 5B

IMAGE PICKUP APPARATUS 100 AND RADIATION GENERATING UNIT 206
  ·OBTAIN IMAGE SIGNAL FOR SENSITIVITY CORRECTION
   OBTAINED THROUGH A/D CONVERSION

CONTROLLER 109
"AVERAGE VALUE OF IMAGE
SIGNALS FOR SENSITIVITY CORRECTION" IS
IN THE VICINITY OF "INFORMATION ON
INPUT-OUTPUT ERROR OF
A/D CONVERTER"? — NO

YES

CONTROLLER 109
  ·DETERMINE AMOUNT OF RADIATION RADIATED FROM
   RADIATION GENERATING UNIT 206

CONTROLLER 109
  ·CHANGE AMOUNT OF RADIATION RADIATED FROM
   RADIATION GENERATING UNIT 206

STORED IN STORAGE UNIT 108
  ·IMAGE SIGNAL FOR SENSITIVITY CORRECTION

FIG. 6A

FIG. 6B

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005210480 A

- JP 2007017650 A